# EUROPEAN PATENT APPLICATION

(11) **EP 1 507 169 A1**
(43) Date of publication of application: **16.02.2005**
(21) Application number: 04018685.0
(22) Date of filing: 06.08.2004
(51) Int. Cl.: G03F 7/00, G03F 7/004, G03F 7/032, G03F 7/30, H01J 9/02, H01J 17/04, C03C 17/34

(54) **Photosensitive thick-film paste materials for forming light-transmitting electromagnetic shields, light-transmitting electromagnetic shields formed using the same, and method of manufacture thereof**

(30) Priority: 15.08.2003 US 495657 P; 15.07.2004 US 891925
(71) Applicant: E. I. du Pont de Nemours and Company, Wilmington, Delaware 19898 (US)
(72) Inventor: Koishikawa. Jun, Sagamihara city, 229-0014 (JP); Tsuchiya, Motohiko, Utsunomiya City 321-0846 (JP); Tsutomu, Mutoh, Utsunomiya City 321-0846 (JP)
(74) Representative: Thomson, James B.

(57) **Abstract**

The present invention relates to light-transmitting electromagnetic shields which, when installed at the front of displays such as plasma display panels (PDP), cathode-ray tubes (CRT) or electroluminescent (EL) displays, have electromagnetic shielding properties that cut down on the emission of electromagnetic waves, have a high visible light transmittance, lower the reflectance to outside light, and have a good durability.

## Description

The present invention relates to light-transmitting electromagnetic shields which, when installed at the front of displays such as plasma display panels (PDP), cathode-ray tubes (CRT) or electroluminescent (EL) displays, have electromagnetic shielding properties that cut down on the emission of electromagnetic waves, have a high visible light transmittance, lower the reflectance to outside light, and have a good durability.

### BACKGROUND OF THE INVENTION

The rising popularity of plasma displays and other large-screen displays has led to a growing interest in technology for shielding the electromagnetic radiation emitted by display devices. In particular, with the growing use of such displays as household TVs, there has been a steady rise worldwide in the proportion of displays whose electromagnetic shielding properties are required to conform to U.S. Federal Communications Commission (FCC) class B standards. At the same time, attention has been shifting from a concern over electromagnetic wave interference (EMI) between machines to electromagnetic compatibility (EMC), and especially the North European standard MARP 2 (a Swedish standard which requires electromagnetic waves over a very broad range of 1 to 1,000 MHz to be cut to a sufficient degree); that is, to the effects of electromagnetic waves on human health. As is apparent from the above, substantially all products in the plasma display TV industry will most likely be required to meet the FCC's Class B standards.

There are currently two major types of light-transmitting electromagnetic shields for plasma displays. One is light-transmitting electromagnet shields obtained by methods that involve forming a metal thin film on a light-transmitting substrate (a supporting substrate such as a glass plate or a transparent film). The other is light-transmitting shields obtained by methods that involve plating or laminating a metal thin-film of copper or the like onto a light-transmitting substrate, then etching the metal thin-film to form a mesh-like pattern.

Advantages of the former method include the ability to produce shields at a relatively low cost and the ease of obtaining visible light transmittance. However, it is difficult in this way to achieve the surface resistivity needed to provide sufficient electromagnetic shielding effects. In the marketplace, this approach is suitable for types of equipment that conform to the FCC's Class A standards.

To conform to Class B of the above standards, the surface resistivity must meet the specification of 1.5 Ω/□ or less, whereas the actual requirement on the market is for a value of 0.1 Ω/□ or less. In fact, the latter of the two above methods is used in almost all Class B devices. Taking into account the ability to achieve properties such as electromagnetic shielding effects, visibility, light-transmitting properties, reflectance and viewing angle, JP-A 10-163673 and JP-A 5-16281 disclose methods for efficiently creating very fine patterns by using electroless plating to form a copper thin film on the surface of a transparent substrate, forming a resist pattern thereon by photolithography, then creating a pattern by an etching process.

However, because the above-described production method involves a large number of steps and are environmentally burdensome, and because their use creates wastewater treatment costs during etching, they are a major factor in elevating production costs and in raising the direct cost of materials for the optical filters in plasma display panels. In addition, with high-definition TV broadcasting and the growing availability of programming in recent years, there exists a desire for displays, and particularly plasma displays, of larger size. This has in turn created a need for larger etching equipment and larger wastewater processing equipment which, given the abrupt rise in the popularity of these displays, has made the above problems increasingly more acute. Moreover, another problem that has been identified with this method is the fact that the thickness of the metal mesh and the metallic gloss on the sidewalls lower the picture quality depending on the viewing angle.

Furthermore, in the above-described method, a light-transmitting electromagnetic shield composed of a metal mesh such as copper foil that has been formed beforehand on a transparent substrate must be laminated or otherwise stacked, with an intervening adhesive film or the like, on half-tempered glass to assure safety. The yield of the above steps, material costs for the laminated film and other factors are part of the reason why, ultimately, production costs for plasma display front filters are not coming down. Also, in these technologies, it has been necessary at the same time to adjust the refractive indices of the transparent film-supporting substrate and the adhesive layer. Moreover, the very existence of an intervening supporting substrate or adhesive layer results in some degree of loss in the transmittance of visible light.

A very few TV manufacturers have managed to reduce electromagnetic waves generated from the plasma display panel itself by circuit modifications and, by using this approach in combination with the above method, are conforming to Class B standards. However, due to high circuit costs and the inability to achieve fully adequate electromagnetic shielding effects, a definitive solution has yet to be achieved.

JP-B 2-48159 discloses an electromagnetic radiation-blocking shield made of an electrically conductive paste that contains a metal powder and a resin and is formed by pattern printing on a transparent substrate.

However, it is difficult to achieve a resolution in the metal areas that provides an adequate aperture ratio by using a printing method alone to form the electromagnetic shield. Accordingly, this approach is not currently being used.

Therefore, in the current market, to enhance the picture quality of plasma display panels, there is a strong desire for materials and processes which provide the surface resistivity required for achieving electromagnetic shielding properties that fully conform with FCC Class B standards while maintaining a low reflectance (high contrast), a high aperture ratio (high visible light transmittance) and a broad viewing angle (use of thin films in the metal areas), and which moreover are environmentally sound and capable of reducing production costs. There is also a strong desire for light-transmitting electromagnetic shields manufactured using such materials and processes.

### Problems to be solved by the Invention

In light of the above-described prior art, the object of the invention is to provide photosensitive thick-film paste materials for forming light-transmitting electromagnetic shields, light-transmitting electromagnetic shields formed from such materials, and methods of manufacturing such electromagnetic shields, which shields have a surface resistivity suitable for obtaining a sufficient electromagnetic shielding effect, excellent light transmittance, non-visibility and broad viewing angle, maintain an outside light reflection-suppressing effect, have a good durability, require fewer production steps than in the prior art and, by making effective use of precious metals such as silver by recycling, are capable of holding down production costs and are environmentally friendly.

### SUMMARY OF THE INVENTION

Accordingly, the photosensitive thick-film paste for forming light-transmitting electromagnetic shields according to Claim 1 is a thick-film paste material obtained by application of a thick-film black paste onto a transparent glass substrate followed by application thereon of a thick-film electrically conductive paste or by lamination of the respective pastes in the form of sheets, exposure of the layers to actinic radiation in a desired geometric pattern, development of the patterned regions of the layer with a solvent, removal of the unexposed regions, firing of the remaining exposed regions that have been patterned in a grid-like manner, removal of the organic components, and sintering of the inorganic components; wherein the thick-film conductive paste or the same paste in the form of a sheet includes a mixture of electrically conductive particles composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer; and the thick-film black paste or the same paste in the form of a sheet includes a mixture of a black pigment made of at least one from among ruthenium oxides, ruthenium polynary oxides, chromium oxides, iron oxide, titanium oxide, carbon black, nickel, nickel borate or a mixture thereof, at least one type of inorganic binder, an organic polymeric binder, a photoinitiator and a photocurable monomer. A lamination method that may be used herein is found in U.S. Patent Application Serial Number 10/275,183 that is incorporated by reference herein.

The light-transmitting electromagnetic shield of Claim 2 is formed by applying onto a transparent glass substrate, or laminating in sheet form, a thick-film black paste composed of a mixture of a black pigment made of at least one from among ruthenium oxides, ruthenium polynary oxides, chromium oxides, iron oxide, titanium oxide, carbon black, nickel, nickel borate or a mixture thereof, at least one type of inorganic binder, an organic polymeric binder, a photoinitiator and a photocurable monomer; applying on top thereof, or laminating in sheet form, a thick-film electrically conductive paste composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer, pattern exposing the layers to actinic radiation in a desired geometric pattern, developing the patterned regions of the layer with a solvent, removing the unexposed regions, firing the remaining exposed regions that have been geometrically patterned, removing the organic components, and sintering the inorganic components.

The light-transmitting electromagnetic shield of Claim 3 is characterized in that the ratio St/Ss between the total surface area St of the above unexposed regions and the total surface area Ss of the regions where the light-transmitting electromagnetic shield has been formed is at least 1 but not more than 99, the linewidth Ws is from 1 to 50 µm, the film thickness T is from 0.1 to 50 µm, and the shield is integrally formed with the substrate glass.

The method of forming a light-transmitting electromagnetic shield of Claim 4 is a method of forming a light-transmitting electromagnetic shield on a transparent glass substrate, which method is characterized by including:
(1) a step in which a thick-film black paste composed of a mixture of a black pigment made of at least one from among ruthenium oxides, ruthenium polynary oxides, chromium oxides, iron oxide, titanium oxide, carbon black, nickel, nickel borate or a mixture thereof, at least one type of inorganic binder, an organic polymeric binder, a photoinitiator and a photocurable monomer is applied, or laminated in sheet form, onto the glass substrate;
(2) a step in which a metal electrically conductive paste composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer is applied, or laminated in sheet form, onto the thick-film black layer;
(3) a step in which the layers are exposed to actinic radiation in a desired geometric pattern so as to definite a specific pattern;
(4) a step in which the exposed photosensitive conductive layer is developed in the patterned regions of the layer with a solvent, and the unexposed regions are removed; and
(5) a step in which the remaining exposed regions that have been geometrically patterned within the developed photosensitive conductive layer are fired, the organic components are removed, and the inorganic components are sintered.

The method of forming a light-transmitting electromagnetic shield of claim 5 is the method according to Claim 4 in which precious metals such as silver, palladium, gold and platinum within the thick-film conductive paste in the unexposed regions that have been removed in development step (4) are refined so as to recycle the precious metal materials.

The method of forming a light-transmitting electromagnetic shield of Claim 6 is the method [according to Claim 4] wherein, in firing step (5), the glass substrate is fired in a tempering furnace or a half-tempering furnace so as to strengthen it, and the photosensitive thick-film layer is sintered at the same time.

The method of forming a light-transmitting electromagnetic shield of Claim 7 is the method according to Claim 4 or 5 which is characterized in that, in the step in which the photosensitive conductive layer is exposed in a grid pattern so as to define a specific pattern, the ratio St/Ss between the total surface area St of the unexposed regions and the total surface area Ss of the regions where the shield pattern has been formed is at least 1 but not more than 99, the linewidth Ws is from 1 to 50 µm, the film thickness T is from 0.1 to 50 µm, and the shield is integrally formed with the substrate glass.

The thick-film black electrically conductive paste material of Claim 8 is a thick-film black conductive paste material for forming a light-transmitting electromagnet shield by application of a thick-film black paste, or lamination of the paste in the form of a sheet, onto a transparent glass substrate, exposure of the layer to actinic radiation in a desired grid-like pattern, development of the patterned regions of the layer with a solvent, removal of the unexposed regions, firing of the remaining exposed regions that have been patterned in a grid-like manner, removal of the organic components, and sintering of the inorganic components; wherein the thick-film black conductive paste, or the same paste in the form of a sheet, is a mixture of a black pigment made of at least one from among ruthenium oxides, ruthenium polynary oxides, chromium oxides, iron oxide, titanium oxide, carbon black, nickel, nickel borate or a mixture thereof, optional conductive particles composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer.

The light-transmitting electromagnetic shield of Claim 9 is formed by applying onto a transparent glass substrate, or laminating in sheet form, a black electrically conductive paste composed of a mixture of a black pigment made of at least one from among ruthenium oxides, ruthenium polynary oxides, chromium oxides, iron oxide, titanium oxide, carbon black, nickel, nickel borate or a mixture thereof, optional conductive particles composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer, exposing the layer to actinic radiation in a desired grid pattern, developing the patterned regions of the layer with a solvent, removing the unexposed regions, firing the remaining exposed regions that have been patterned in a grid-like manner, removing the organic components, and sintering the inorganic components.

The light-transmitting electromagnetic shield of Claim 10 is characterized in that the ratio St/Ss between the total surface area St of the above unexposed regions and the total surface area Ss of the regions where the light-transmitting electromagnetic shield has been formed is at least 1 but not more than 99, the linewidth Ws is from 1 to 50 µm, the film thickness T is from 0.1 to 50 µm, and the shield is integrally formed with the substrate glass.

The method of forming a light-transmitting electromagnetic shield of Claim 11 is a method of forming a light-transmitting electromagnetic shield on a transparent glass substrate, which method is characterized by including:
(a) a step in which a black electrically conductive paste composed of a mixture of a black pigment made of at least one from among ruthenium oxides, ruthenium polynary oxides, chromium oxides, iron oxide, titanium oxide, carbon black, nickel, nickel borate or a mixture thereof, optional conductive particles composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer is applied, or laminated in sheet form, onto the glass substrate;
(b) a step in which the layers are exposed to actinic radiation in a desired geometric pattern so as to definite a specific pattern;
(c) a step in which the exposed photosensitive conductive layer is developed in the patterned regions of the layer with a solvent, and the unexposed regions are removed; and
(d) a step in which the remaining exposed regions that have been patterned in a grid-like manner within the developed photosensitive conductive layer are fired, the organic components are removed, and the inorganic components are sintered.

The method of forming a light-transmitting electromagnetic shield of Claim 12 is characterized in that precious metals such as silver, palladium, gold and platinum within the thick-film conductive paste in the unexposed regions that have been removed in above development step (c) are refined so as to recycle the precious metal materials.

The method of forming a light-transmitting electromagnetic shield of claim 13 which is characterized in that, in the firing step (d), the glass substrate is fired in a tempering furnace or a half-tempering furnace so as to strengthen the glass substrate, and the photosensitive thick-film layer is sintered at the same time.

The method of forming a light-transmitting electromagnetic shield of Claim 14 is characterized in that, in the step in which the photosensitive conductive layer is exposed in a grid pattern so as to define a specific pattern, the ratio St/Ss between the total surface area St of the unexposed regions and the total surface area Ss of the regions where the light-transmitting electromagnetic shield has been formed is at least 1 but not more than 99, the linewidth Ws is from 1 to 50 µm, the film thickness T is from 0.1 to 50 µm, and the shield is integrally formed with the substrate glass.

### BRIEF DESCRIPTION OF DRAWINGS

FIG. 1 is a schematic diagram showing a light-transmitting electromagnetic shield member 1 fabricated in accordance with this invention.
FIG. 2 represents one embodiment of a method of forming a light-transmitting electromagnetic shield according to the present invention.

### DETAILED DESCRIPTION

### Mode for Carrying Out the Invention

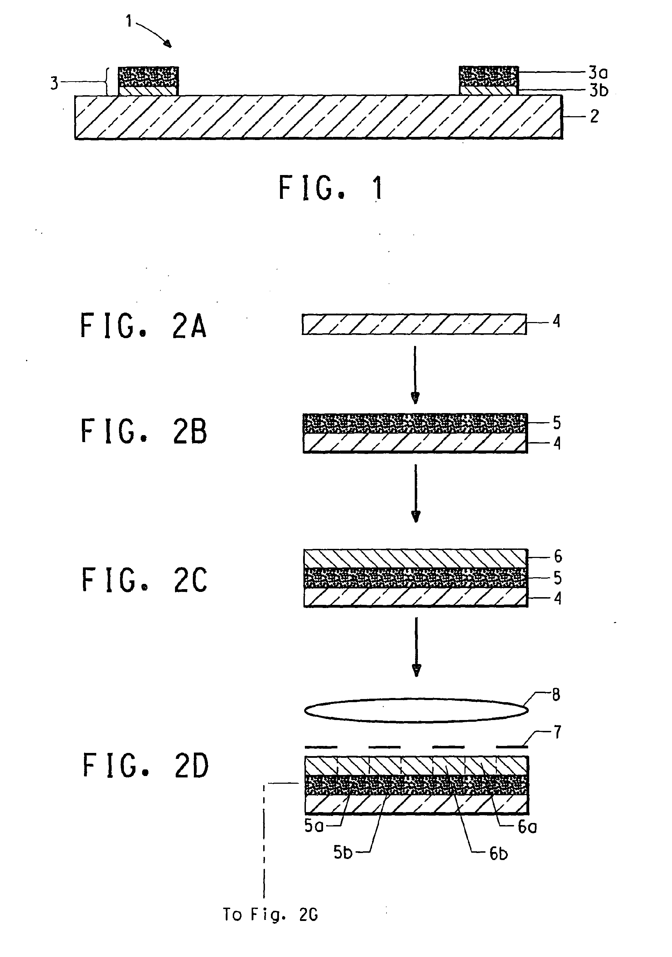

FIG. 1 is a schematic diagram showing a light-transmitting electromagnetic shield member 1 fabricated in accordance with this invention. A photosensitive thick-film electrically conductive paste which contains a conductive powder and a photosensitive resin and a photosensitive thick-film black paste which contains a black pigment and a photosensitive resin are applied by screen printing onto the surface of a glass substrate 2. The places where an electromagnetic shield pattern having a predetermined geometric pattern are to remain are exposed to UV light through a photomask and developed, following which they are fired in a horizontal profile furnace or a horizontal half-tempering furnace to form an electromagnetic shield pattern 3 having a black layer 3a and 3b [sic]. The ratio St/Ss between the total surface area St of the unexposed regions and the total surface area Ss of the regions where the light-transmitting electromagnetic shield has been formed is at least 1 but not more than 99, the linewidth Ws is from 1 to 50 µm, the film thickness T is from 0.1 to 50 µm, and the shield is integrally formed with the substrate glass.

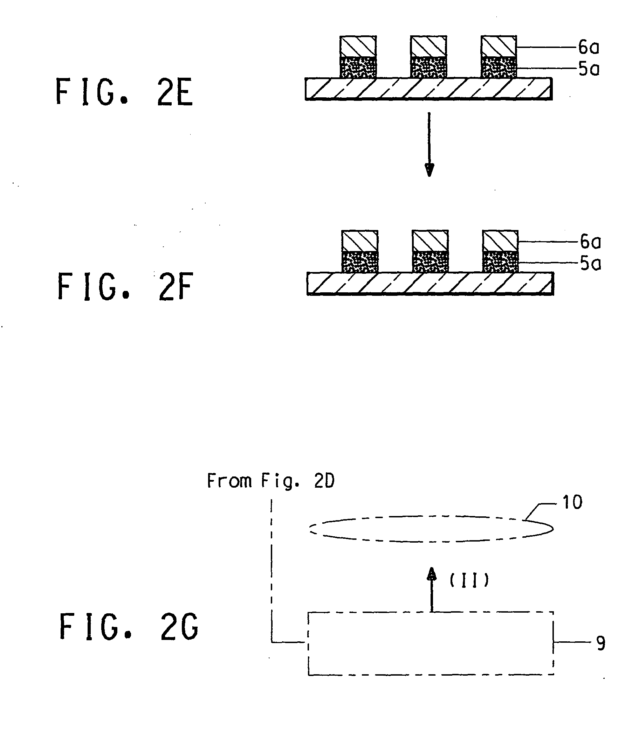

The method of forming a light-transmitting electromagnetic shield according to one embodiment of the invention is described below while referring to FIG. 2. This method includes the following sequence of steps.
(A) A step in which the thick-film black paste is applied, or laminated in sheet form, onto a soda lime glass substrate 4 (such as one made of a high yield point glass) in the same way as conventional methods known in the art to which the invention relates. The thick-film black paste, or the same paste in sheet form, includes a mixture of (a) at least one type of electrically conductive particle from among RuO₂, ruthenium polynary oxides and mixtures thereof and, optionally, additional conductive particles composed of at least one type of metal selected from among gold, silver, palladium, platinum and copper, or a combination thereof (in the presence of copper, a non-reducing atmosphere does not have to be used), (b) at least one type of inorganic binder, (c) an organic polymeric binder, (d) a photoinitiator and (e) a photocurable monomer (FIG. 2A).
(B) A step in which a photosensitive thick-film electrically conductive silver composition layer 6 (which composition is applied as a paste or is in sheet form) that forms a silver electrode is placed on the black conductive [layer] applied initially as a paste or in sheet form. The photosensitive thick-film conductive composition layer includes a mixture of (a) electrically conductive particles of at least one type selected from the group consisting of gold, silver, palladium, platinum and copper, or a combination thereof, (b) at least one type of inorganic binder, (c) an organic polymeric binder, (d) a photoinitiator, and (e) a photocurable monomer (FIG. 2B). Steps A and B may each be followed by a step that involves oven drying in a nitrogen or open-air atmosphere and at 75 to 100°C.
(C) A step in which the black conductive paste (or a sheet thereof) and the silver conductive paste (or a sheet thereof) which have been arranged so as to correlate with the shield pattern are imagewise exposed for a predetermined optimal exposure time through a photomask 7 having a shape corresponding to a pattern by carrying out exposure of the first black layer 5 and the second silver conductive layer 6 to actinic radiation (using primarily UV sources) using an aligner 8 so as to obtain the correct outline following development and thus define an electrode pattern having a geometric pattern (FIG. 2C).
(D) A step in which the exposed areas 5a and 6a of the first black layer 5 and the second silver conductive layer 6 are developed in a basic aqueous solution which is an aqueous solution of 0.8 wt % sodium carbonate or another alkali, and the unexposed areas 5b and 6b of layers 5 and 6 are removed (FIG. 2D). If necessary, the developed product is dried with an air blower under predetermined conditions so as to evaporate off the residual moisture.
(E) A step in which exposed areas 5a and 6a are fired at a temperature of 500 to 700°C, depending on the substrate material, so as to sinter the inorganic binder and the conductive components (FIG. 2E).
(F) An optional step in which the glass is quenched by forced air cooling immediately after firing to temper it (FIG. 2F).
(G) When precious metals such as gold, silver, platinum and palladium are present as metal components within the photosensitive thick-film conductive paste in the unexposed areas that are removed in above step D, as is commonly done in the electronic components manufacturing market where thick-film pastes are used, by having an enterprise capable of recovering precious metals, such as Matsuda Sangyo Co., Ltd., recover these precious metals present in the developer with filters and re-refine them, a step 8 is possible in which precious metals of value are recycled and used either in coins or restored as the precious metals themselves to the paste manufacturer or electromagnetic shield manufacturer 10.

The components in the photosensitive black conductive paste or sheet form thereof used in the invention are described below.

### (A) Thick-Film Black Paste or Sheet Form Thereof:

The black composition used in the invention contains RuO₂ and/or ruthenium polynary oxides. These conductive particles may optionally contain precious metals which include gold, silver, platinum, palladium, copper or combinations thereof which are described below in section (B). Ruthenium polynary oxides are one type of pyrochlore, which is a polynary compound of Ru⁺⁴, Ir⁺⁴ or mixtures (M") thereof having the following general formula:

(MₓBi₂₋ₓ)(M'_{y}M"_{2-y})O_{7-z}

In the formula, M is selected from the group consisting of yttrium, thallium, indium, cadmium, lead, copper and rare-earth compounds; M' is selected from the group consisting of platinum, titanium, chromium, rhodium and antimony; M" is selected from the group consisting of ruthenium, iridium and mixtures thereof; the letter x is from 0 to 2, but is less than or equal to 1 (≤1 ) for monovalent copper; the letter y is from 0 to 0.5, but is from 0 to 1 if M' is rhodium or a plurality of metals selected from among platinum, titanium, chromium, rhodium and antimony; and the letter z is from 0 to 1, but is at least about x/2 when M is divalent lead or cadmium.

The above ruthenium-based pyrochlore oxides are described in detail in U.S. Patent No. 3,583,931. Preferred ruthenium polynary oxides include ruthenium bismuth oxide Bi₂Ru₂O₇, ruthenium lead oxide Pb₂Ru₂O₆, Pb_{1.5}-BiO_{0.5}-Ru₂O_{6.5} and GdBiRu₂O₆. These substances are readily available in purified form, are not adversely affected by glass binders, are stable even when heated in air to about 1,000°C, and are relatively stable even in a reducing atmosphere.

The ruthenium oxide and/or ruthenium-based pyrochlore oxides are used in a proportion, based on the weight of the overall composition, including organic medium, of 4 to 50 wt %, preferably 6 to 30 wt %, more preferably 5 to 15 wt %, and most preferably 9 to 12 wt %.

### (B) Conductive Metal Particles in Black Conductive Paste or Sheet Form Thereof:

An electrically conductive metal may, if necessary, be added to the black composition. Metal powder of substantially any form, including spherical particles and flakes (of rod-like, conical or tabular shape), may be used to work the invention. Preferred metal powders include gold, silver, palladium, platinum, copper and combinations thereof. The powder is preferably spherical. We know that, in this invention, the metal particle-dispersing liquid must not contain a significant amount of solids having a particle size of less than 0.2 µm. In cases where the film or layer of organic medium is fired to remove the organic medium and carry out sintering of the inorganic binder and the metal solids, the presence of such tiny particles makes complete combustion of the organic medium difficult. Generally, when a dispersion liquid is used to prepare a thick-film paste, the maximum particle size should not exceed the screen thickness. It is preferable for at least 80 wt % of the electrically conductive solids to fall within a range of 0.5 to 10 µm.

Moreover, it is preferable for the surface area/weight ratio of the conductive particles to not exceed 20 m²/g, preferably 10 m²/g, and most preferably 5 m²/g. If metal particles having a surface area/weight ratio that exceeds 20 m²/g are employed, this adversely affects the sintering properties of both inorganic binders used. Thorough combustion of the organic medium is difficult, and blisters appear.

Copper oxide is often added to the conductive particles to improve adhesion. The copper oxide should be used in the form of finely milled particles, preferably having a size of about 0.5 to 5 microns. When present as Cu₂O, the copper oxide is used in an amount, based on the overall composition, of about 0.1 to 3 wt %, and preferably about 0.1 to 1.0 wt %. Some or all of the Cu₂O may be substituted with equimolar CuO.

### (C) Inorganic Binder:

The inorganic binders such as glass or frit used in the invention serve to promote sintering of the conductive component particles. Use may be made of inorganic binders of any composition known to the art to which the invention relates that have a softening point lower than the melting point of the conductive component. The softening point of the inorganic binder exerts a large influence on the sintering temperature. For thorough sintering of the composition on the underlying layer, it is advantageous that the electrically conductive composition in the present invention have a glass softening point of about 325 to 700°C, preferably about 350 to 650°C, and most preferably about 375 to 600°C.

When melting occurs at a temperature lower than 325°C, the organic substances readily become trapped therein, as a result of which blisters tend to arise in the composition as the organic substance decomposes. On the other hand, at a softening point greater than 700°C, the adhesion of the composition tends to weaken.

The most preferred glass frit is a borosilicate frit in combination with salts of lead, bismuth, cadmium, barium, calcium or other alkaline earth metals. Methods of preparing such glass flits are well-known in the field to which the invention relates. In one such method, the glass components are melted together as the oxides of the respective components, and the molten composition is poured into water to obtain the frit. The components used in the batch may be any compounds which form the desired oxides under ordinary frit production conditions. For example, the boron oxide can be obtained from boric acid, silicon dioxide can be obtained from flint, and barium oxide can be obtained from barium carbonate.

The solid composition must not agglomerate, and so the frit is passed through a fine screen to remove large particles. The inorganic binder must be set to a surface area/weight ratio of 10 m²/g or less. It is preferable for at least 90 wt % of the particles to have a particle size of from 0.4 to 10 µm.

It is preferable for the inorganic binder to account for 0.01 to 25 wt % of the conductive or dielectric particles. Too large a proportion of inorganic binder may weaken the ability to bond to the substrate.

### (D) Organic Polymeric Binder:

The polymeric binder is important to the composition of the invention. The polymeric binder should be selected after taking into account the aqueous developability; a polymeric binder having a high resolution must be selected. The following binders are known to satisfy these conditions. These binders are copolymers or interpolymers prepared from (1) non-acidic comonomers containing C₁₋₁₀ alkyl acrylates, C₁₋₁₀ alkyl methacrylate, styrene, substituted styrene or combinations thereof, and (2) acidic comonomers having ethylenically unsaturated carboxylic acid-containing portions which represent at least 15 wt % of the total polymer weight.

The presence of acidic comonomer components in the composition is important to the present art. The acidic functional groups enable the composition to be developed in an aqueous base such as a 0.8% aqueous solution of sodium carbonate. If the acidic comonomer is present in a concentration of less than 15%, the composition cannot be completely washed away with an aqueous base. When the acidic comonomer is present in a concentration that exceeds 30%, the composition has a low stability under the development conditions, so that only partial development occurs in the pattern-forming areas. Suitable acidic comonomers include ethylenically unsaturated monocarboxylic acids such as acrylic acid, methacrylic acid and crotonic acid; ethylenically unsaturated dicarboxylic acids such as fumaric acid, itaconic acid, citraconic acid, vinylsuccinic acid and maleic acid, as well as hemiesters thereof and also, in some cases, anhydrides thereof, and mixtures of any of the above. Because they can be burned more cleanly in a low oxygen atmosphere, methacrylic polymers are preferable to acrylic polymers.

When the non-acidic comonomers are the above-described alkyl acrylates or alkyl methacrylates, it is advantageous for these non-acidic comonomers to make up preferably at least 50 wt %, and most preferably 70 to 75 wt %, of the polymeric binder. In cases where the non-acidic comonomer is styrene or a substituted styrene, the non-acidic comonomer is preferably 50 wt % composed of polymeric binder, with the remaining 50 wt % being acid anhydrides such as the hemiester of maleic anhydride. An example of a preferred substituted styrene is α-methylstyrene.

Although not desirable, the non-acidic portion of the polymeric binder can include up to about 50 wt % of other non-acidic comonomers in place of the alkyl acrylate, alkyl methacrylate, styrene and substituted styrene portions of the polymer. Illustrative examples include acrylonitrile, vinyl acetate and acrylamide. However, because complete combustion in this type of case is more difficult to achieve, such monomers are preferably used in an amount of less than about 25 wt % of the overall polymeric binder. The use of a single copolymer or a combination of copolymers as the binder is acceptable so long as each of the above conditions is satisfied. In addition to the above copolymer, a small amount of other polymeric binders can also be used. Examples include polyolefins such as polyethylene, polypropylene, polybutylene, polyisoprene and ethylene-propylene copolymers, as well as polyethers which are lower alkylene oxide polymers such as polyethylene oxide.

These polymers can be prepared by liquid polymerization techniques that are commonly used in the field of acrylate polymerization.

In a typical example, an acidic acrylate polymer such as that described above is prepared by mixing an α- or β-ethylenically unsaturated acid (acidic comonomer) in a relatively low-boiling (75 to 150°C) organic medium together with one or more type of copolymerizable vinyl monomer (non-acidic comonomer) to form a 10 to 60% monomer mixture solution. Polymerization is then carried out by adding a polymerization catalyst to the resulting monomer. The resulting mixture is subsequently heated to the refluxing temperature of the solvent at the ambient pressure. Once the polymerization reaction is substantially complete, the acidic polymer solution that has formed is cooled to room temperature, a sample is collected, and the viscosity, molecular weight and acid equivalence of the polymer are measured.

In addition, the above-described acid-containing polymeric binder must be held to a molecular weight of less than 50,000, preferably less than 25,000, and most preferably less than 15,000.

In cases where the above composition is applied by screen printing, it is advantageous for the glass transition temperature (Tg) of the polymeric binder to exceed 90°C.

After screen printing, the above paste is generally dried at a temperature of up to 90°C. If the Tg value of the polymer binder is lower than this temperature, the composition generally has a very high adhesive properties. Substances having a lower Tg value can be employed when the composition is applied by a means other than screen printing.

The organic polymeric binder generally is present in an amount of 5 to 45 wt %, based on the overall amount of the dried photopolymerizable layer.

### (E) Photoinitiator:

Preferred photoinitiators are those which, when exposed to actinic radiation at a temperature of up to 185°C, are thermally inert but generate free radicals. These photoinitiators include substituted or unsubstituted polynuclear quinones, which are compounds having two intramolecular rings within a covalent carbon ring system. Illustrative examples include 9,10-anthraquinone, 2-methylanthraquinone, 2-t-butylanthraquinone, octamethylanthraquinone, 1,4-naphthoquinone, 9,10-phenanthrenequinone, benzo[1]anthracen-7,12-dione, 2,3-naphthacen-5,12-dione, 2-methyl-1,4-naphthoquinone, 1,4-dimethylanthraquinone, 2,3-dimethylanthraquinone, 2-phenylanthraquinone, 2,3-diphenylanthraquinone, retenequinone, 7,8,9,10-tetrahydronaphthacen-5,12-dione and 1,2,3,4-tetrahydrobenzo[a]anthracen-7,12-dione. Other useful photoinitiators include those mentioned in U.S. Patent No. 2,760,863 (of which several are thermally active even at a low temperature such as 85°C, vicinal ketoaldonyl alcohols such as benzoin and pivaloin; acyloin ethers such as the methyl and ethyl ethers of benzoin; and hydrocarbon-substituted aromatic acyloins such as α-methylbenzoin, α-allylbenzoin, α-phenylbenzoin, thioxanthone and its derivatives, and hydrogen donor-containing hydrocarbon-substituted aromatic acyloins.

Initiators that may be used include photoreducible dyes and reducing agents. These include initiators mentioned in U.S. Patent Nos. 2,850,445, 2,875,047, 3,097,96 [sic], 3,074,974, 3,097,097 and 3,145,104; phenazines, oxazines and quinones, such as Michler's ketone, ethyl Michler's ketone and benzophenone, dimers of leuco dye-containing hydrogen donors with 2,4,5-triphenylimidazolyl compounds, and mixtures of the above (mentioned in U.S. Patent Nos. 3,427,161, 3,479,185 and 3,549,367. Moreover, the sensitizers mentioned in U.S. patent No. 4,162,162 are useful together with photoinitiators and photoinhibitors. The photoinitiator or photoinitiator system is included in an amount of 0.05 to 10 wt %, based on the total weight of the dried photopolymerizable layer.

### (F) Photocurable Monomer:

The photocurable monomer components used in this invention include at least one type of addition polymerizable ethylenically unsaturated compound having at least one polymerizable ethylene group.

This type of compound can initiate polymer formation by the presence of free radicals, enabling chain extension addition polymerization. This monomer compound is non-gaseous, has a boiling point higher than 100°C, and has the effect of imparting plasticity to the organic polymeric binder. Monomers which can be used alone or in combination with other monomers include t-butyl (meth)acrylate, 1,5-pentanediol di(meth)acrylate, N,N-dimethylaminoethyl (meth)acrylate, ethylene glycol di(meth)acrylate, 1,4-butanediol di(meth)acrylate, diethylene glycol di(meth)acrylate, hexamethylene glycol di(meth)acrylate, 1,3-propanediol di(meth)acrylate, hexamethylene glycol di(meth)acrylate, 1,4-cyclohexanediol di(meth)acrylate, 2,2-dimethylolpropane di(meth)acrylate, glycerol di(meth)acrylate, tripropylene glycol di(meth)acrylate, glycerol tri(meth)acrylate, trimethylol propane tri(meth)acrylate, the compounds mentioned in U.S. Patent No. 3,380,381, 2,2-di(p-hydroxyphenyl)propane di(meth)acrylate, pentaerythritol tetra(meth)acrylate, triethylene glycol diacrylate, polyoxethyl-1,2-di-(p-hydroxyethyl)propane dimethacrylate, bisphenyl A di-[3-(meth)acryloxy-2-hydroxypropyl) ether, bisphenol A di-[2-(meth)acryloxyethyl)ether, 1,4-butanedioldi-(3-methacryloxy-2-hydroxypropyl) ether, triethylene glycol dimethacrylate, polyoxypropyltrimethylolpropane triacrylate, butylene glycol di(meth)acrylate, 1,2,4-butanediol tri(meth)acrylate, 2,2,4-trimethyl-1,3-pentanediol di(meth)acrylate, 1-phenylethylene-1,2-dimethacrylate, diallyl fumarate, styrene, 1,4-benzenediol dimethacrylate, 1,4-diisopropenyl benzene and 1,3,5-triisopropenylbenzene (here, "(meth)acrylate" is used as an abbreviation representing both acrylate and methacrylate).

Useful examples include ethylenically unsaturated compounds having a molecular weight of at least 300, such as alkylene glycols or polyalkylene glycols which are C₂₋₁₅ alkylene glycols having 1 to 10 ether bonds; and alkylene or polyalkylene glycol diacrylates mentioned in U.S. Patent No. 2,927,022, such as those which, particularly when present as the end group, are prepared from addition polymerizable ethylene bond-bearing compounds.

Other useful monomers are disclosed in U.S. Patent No. 5,032,490. Preferred monomers are polyoxyethylated trimethylolpropane tri(meth)acrylate, ethylated pentaerythritol triacrylate, trimethylolpropane tri(meth)acrylate, dipentaerythritol monohydroxypentaacrylate and 1,10-decanediol dimethacrylate.

Other preferred monomers include monohydroxypolycaprolactone monoacrylate, polyethylene glycol diacrylate (molecular weight, about 200) and polyethylene glycol dimethacrylate (molecular weight, about 400). The unsaturated monomer component is included in an amount of 1 to 20 wt %, based on the total weight of the dried photopolymerizable layer.

### (G) Organic Medium:

The main purpose for using an organic medium is to have it function as a medium which is capable of rendering a liquid dispersion of finely milled solids of the above-described composition into a form that can easily be applied onto a ceramic or other type of substrate. Accordingly, the organic medium must first be a substance capable of dispersing the solids while maintaining a suitable degree of stability. Secondly, the rheological properties of the organic medium must confer good coating properties to the liquid dispersion.

In organic media, the solvent component (which may be a solvent mixture) selected is one in which the polymer and other organic components completely dissolve. A solvent which is inert to (non-reactive with) the paste composition and other components must be selected. The solvent selected must be one which has a sufficiently high volatility and which can evaporate from a liquid dispersion even when applied at atmospheric pressure and a relatively low temperature. However, it must not have such a degree of volatility that the paste on the screen dries rapidly at normal room temperature during the printing step. Solvents preferable for use in the paste composition are those which have a boiling point at ambient pressure of less than 300°C, and preferably less than 250°C. Illustrative examples of such solvents include aliphatic alcohols; esters of such alcohols, such as the acetic acid ester or propionic acid ester; terpenes such as rosin, α- or β-terpineol, and mixtures thereof; ethylene glycol esters such as ethylene glycol, ethylene glycol monobutyl ether and butyl cellosolve acetate; carbitol esters such as butyl carbitol, butyl carbitol acetate and carbitol acetate; and other suitable solvents such as Texanol (2,2,4-trimethyl-1 ,3-pentanediol monoisobutyrate).

### (H) Additional Components:

Such additional components known in the art to which the invention relates as dispersants, stabilizers, plasticizers, release agents, dispersants [sic], stripping agents, anti-foaming agents and wetting agents may also be included in the composition. A general list of suitable substances appears in U.S. Patent No. 5,32,490 [sic].

### Photosensitive Thick-Film Conductive Paste or Sheet Thereof

The metal electrically conductive composition (in paste or sheet form) used in this invention is a commercial photosensitive thick-film conductor composition. Preferred compositions for use in this invention include silver powder, UV-polymerizable carrier and glass frit.

The conductor phase is a main component of the composition. It is composed of silver particles having a particle size within a range of 0.05 to 20 µm and having a shape which may be random or in the form of flakes. In cases where a UV-polymerizable medium is used together with the composition, it is preferable for the silver particles to have a size within a range of 0.3 to 10 µm. Preferred compositions contain the silver particles in a proportion of 66 wt %, based on the combined amount of all the components in the thick-film paste. In this case, the surface area of the silver particles is 0.34 m²/g.

The metal conductive composition contains, as finely milled inorganic particles, from 1 to 10 wt % of a refractory substance that does not form a glass, or a precursor thereof. Illustrative examples include aluminum oxide, copper oxide, cadmium oxide, gadolinium oxide, zirconium oxide, cobalt oxide/iron/chromium, aluminum and copper. These oxides or oxide precursors have a particle size within a range of 0.05 to 44 µm, and at least 80 wt % of the particles have a size within a range of 0.1 to 5 µm. This composition contains 5 to 20 wt % of glass frit having a softening point within a range of 325 to 600°C. Preferred glass frits are borosilicate-lead glasses. The following composition is especially preferred: PbO (53.1), B₂O₃ (2.9), SiO₂ (29.0), TiO₂ (3.0), ZrO₂ (3.0), ZnO (2.0), Na₂O (3.0) and CdO (4.0). Such a glass frit and suitable additives are formulated so that, when fine lines of fired metal oxides are immersed for one hour in a molten coating agent at 600°C, neither reaction nor dissolution will occur, failure will not take place and adhesion to the underlying black electrode will remain intact.

The metal conductive composition may additionally include 10 to 30 wt % of a photosensitive medium in which the above-described granular substances are dispersed. An example of this type of photosensitive medium is a solution of methyl polymethacrylate and a polyfunctional monomer. This monomer should be one having a low volatility in order to minimize volatilization during preparation of the silver conductor composition paste and during the printing/drying steps prior to carrying out UV curing. The photosensitive medium includes also a solvent and a UV-sensitive initiator. Preferred UV-polymerizable media include polymers based on methyl methacrylate/ethyl acrylate in a weight ratio of 95:5. Moreover, the above-described silver conductor composition is formulated as a free-flowing paste having a viscosity of 50 to 200 Pa·s.

Non-limiting examples of suitable solvents for the above-described medium include butyl carbitol acetate and β-terpineol. These solvents can additionally include, for example, dispersants and stabilizers.

This metal conductive composition may have applied thereon a coating agent composition containing 85 parts of glass frit (composition (mol %): PbO, 68.2; SiO₂, 12.0; B₂O₃, 14.1; CdO, 5.7; softening point, 480) and 14 parts of ethyl cellulose carrier. The resulting coated electrode assembly is useful for the fabrication of AC plasma display panels.

### EXAMPLES

Amounts of all components making up the compositions in each example are indicated in parts.

FODEL® silver paste made by DuPont was used as the photosensitive thick-film electrically conductive paste, FODEL® ruthenium oxide paste made by DuPont was used as the photosensitive thick-film black paste, and soda lime glass having a thickness of 2.5 to 3 mm was used as the glass substrate. To achieve a good visibility, the glass substrate was required to be one of good quality, without defects such as internal air bubbles and surface scratches.

The FODEL® ruthenium oxide paste (made by DuPont) used as the photosensitive thick-film black paste was screen-printed onto a 2x3 inch glass substrate (high-yield point glass PD200, made by Asahi Glass Co., Ltd.) using a 380 mesh polyester screen and dried in a batch-type hot air drying furnace at a peak temperature of 80°C and a total 20-minute profile to form a dry film of the photosensitive thick-film black paste FODEL® DC246 (DuPont).

Next, the photosensitive thick-film silver paste FODEL® silver paste (made by DuPont) was lamination coated by a screen printing process using a 350 calender mesh polyester screen onto the dry film of photosensitive thick-film black paste that had been formed on the glass substrate, then fired in a batch hot-air drying furnace at a peak temperature of 80°C and a total 20-minute profile, thereby forming a dry film composed of two layers: the dried photosensitive thick-film black paste FODEL® ruthenium oxide (made by DuPont) and the photosensitive thick-film silver paste FODEL® silver paste (made by DuPont).

Although the high yield point glass PD200 made by Asahi Glass was used as the glass substrate in this case, any soda lime glass generally available on the market may be used.

Next, using an aligner having an exposure wavelength centered at 365 nanometers, the dry film composed of two layers was exposed, through a photomask bearing a geometric pattern corresponding to a shield pattern, in regions where the shield pattern was to be formed, thereby defined the irradiated region as a shield pattern.

The exposed substrate was subsequently shower developed with 0.4% aqueous sodium carbonate using a planar developing machine and the unexposed areas of the two-layer dry film were removed, thereby giving a dry film composed of the above-described two layers in a shield pattern.

The glass substrate on which the above two-layer dry film was formed in the above-described shield pattern was then air-dried in a horizontal near-infrared firing furnace at a peak temperature of 700°C for a total of 7 minutes so as to sinter the two layers and fix them to the glass substrate, thereby yielding the desired light-transmitting electromagnetic shield member.

Table 1 shows the results obtained from examining the appearance after firing in each of Examples 1 to 4 according to the invention, as well as the resolution (linewidth and line pitch), exposure energy and conditions during development in each case.

The development time is defined here as the "time to clear" (TTC); that is, the time required for development of all the unexposed dry material. The development time in Table 1 is given as a ratio with respect to the TTC.

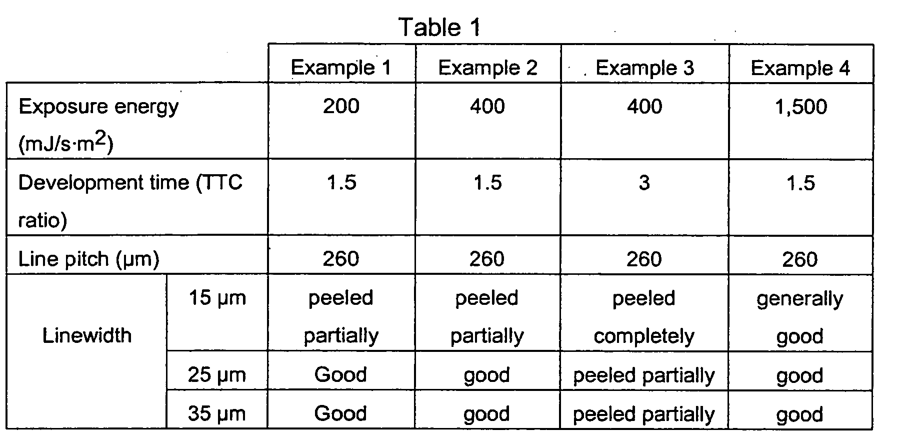

In Example 4, the surface resistivity (measured with a four-probe resistivity meter), aperture ratio (measured using a contact-type measuring instrument manufactured by Tokyo Seimitsu Co., Ltd.) and the visible light transmittance were measured. With regard to the visible light transmittance, the value for just the electromagnetic shield without the glass substrate was used for the sake of comparison. In this invention, unlike in the prior art, there is no need for a support such as a transparent film. Hence, the numerical value for the visible light transmittance coincides with the aperture ratio. The results are shown in Table 2 together with the results obtained in the comparative examples.

### Comparative Example 1

A commercially available electromagnetic shield mesh for use as a front filter in plasma display panels (made by Nippon Filcon Co., Ltd.) was used as a control for the sake of comparison. This was constructed of a 125 thick µm PET film on which was laminated an etched mesh of 10 µm thick copper foil over an intervening adhesive layer having a thickness of about 15 µm. The numerical values were taken from the company's product catalog. This company has a market share in the PDP front filter market of at least two-thirds, and was judged to be the most suitable as a control for comparison with the present invention.

### Comparative Example 2 (Reference)

The surface resistivity required to conform to the U.S. Federal Communication Commission's Class B standards (i.e., 1.5 Ω/□ or less) was shown as a comparative value. Yet, as is apparent from the catalog value for the electromagnetic shield mesh made by Nippon Filcon Co., Ltd., in the market, a value of 0.1 Ω/□ or less is in fact required. The latter was thus regarded as the value actually demanded for practical purposes.

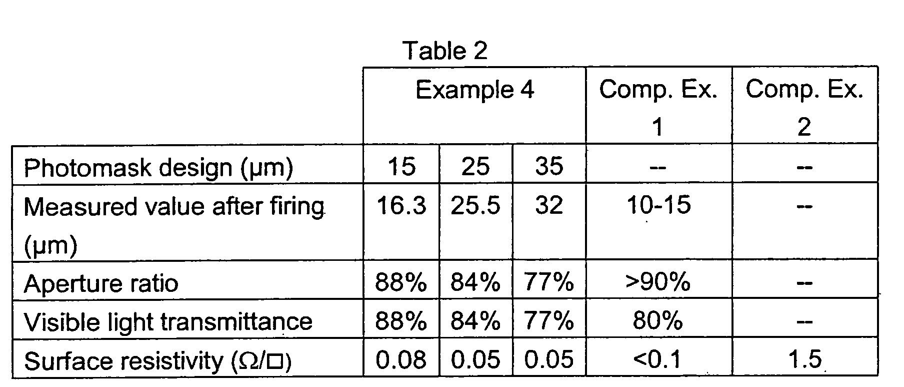

### Advantages of the Invention:

The present invention provides photosensitive electrically conductive paste materials for forming light-transmitting electromagnet shields which have a sufficient electromagnetic shielding effect, excellent light-transmitting properties, non-visibility and viewing angle; possess sufficient durability while maintaining outside light reflection-suppressing effects; are able to reduce the number of steps compared with the prior art; allow the effective reuse of precious metals such as silver by recycling, thereby helping to hold down production costs; and at the same time are very environmentally friendly. This invention also provides light-transmitting electromagnetic shields formed from such paste materials, and a method of fabricating such shields.

## Claims

1. A photosensitive thick-film paste material for forming a light-transmitting electromagnetic shield by application of a thick-film black paste onto a transparent glass substrate followed by application thereon of a thick-film electrically conductive paste or by lamination of the respective pastes in the form of sheets, exposure of the layers to actinic radiation in a desired geometric pattern, development of the patterned regions of the layer with a solvent, removal of the unexposed regions, firing of the remaining exposed regions that have been geometrically patterned, removal of the organic components, and sintering of the inorganic components; wherein the thick-film conductive paste or the same paste in the form of a sheet includes a mixture of electrically conductive particles composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer; and the thick-film black paste or the same paste in the form of a sheet includes a mixture of a black pigment made of at least one from among ruthenium oxides, ruthenium polynary oxides, chromium oxides, iron oxide, titanium oxide, carbon black, nickel, nickel borate or a mixture thereof, at least one type of inorganic binder, an organic polymeric binder, a photoinitiator and a photocurable monomer.

2. A light-transmitting electromagnetic shield that is formed by applying, or laminating in sheet form, onto a transparent glass substrate a thick-film black paste composed of a mixture of a black pigment made of at least one from among ruthenium oxides, ruthenium polynary oxides, chromium oxides, iron oxide, titanium oxide, carbon black, nickel, nickel borate or a mixture thereof, at least one type of inorganic binder, a carboxylic acid-containing organic polymeric binder, a photoinitiator and a photocurable monomer; applying or laminating in sheet form on top thereof a thick-film electrically conductive paste composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer, exposing the layers to actinic radiation in a geometric pattern, developing the patterned regions of the layer with a solvent, removing the unexposed regions, firing the remaining exposed regions that have been geometrically patterned, removing the organic components, and sintering the inorganic components.

3. The light-transmitting electromagnetic shield of claim 2 which is **characterized in that** the ratio St/Ss between the total surface area St of the unexposed regions and the total surface area Ss of the regions where the light-transmitting electromagnetic shield has been formed is at least 1 but not more than 99, the linewidth Ws is from 1 to 50 µm, the film thickness T is from 0.1 to 50 µm, and the shield is integrally formed with the substrate glass.

4. A method of forming a light-transmitting electromagnetic shield on a transparent glass substrate, the method being **characterized by** including:
(1) a step in which a thick-film black paste composed of a mixture of a black pigment made of at least one from among ruthenium oxides, ruthenium polynary oxides, chromium oxides, iron oxide, titanium oxide, carbon black, nickel, nickel borate or a mixture thereof, at least one type of inorganic binder, an organic polymeric binder, a photoinitiator and a photocurable monomer is applied, or laminated in sheet form, onto the glass substrate;
(2) a step in which a metal electrically conductive paste composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer is applied, or laminated in sheet form, onto the thick-film black layer;
(3) a step in which the layers are exposed to actinic radiation in a desired geometric pattern so as to definite a specific pattern;
(4) a step in which the exposed photosensitive conductive layer is developed in the patterned regions of the layer with a solvent, and the unexposed regions are removed; and
(5) a step in which the remaining exposed regions that have been geometrically patterned within the developed photosensitive conductive layer are fired, the organic components are removed, and the inorganic components are sintered.

5. The method of forming a light-transmitting electromagnetic shield of claim 4 which is **characterized in that** precious metals such as silver, palladium, gold and platinum within the thick-film conductive paste in the unexposed regions that have been removed in the development step (4) are refined so as to recycle the precious metal materials.

6. The method of forming a light-transmitting electromagnetic shield of claim 4 which is **characterized in that**, in the firing step (5), the glass substrate is fired in a tempering furnace or a half-tempering furnace so as to strengthen it, and the photosensitive thick-film layer is sintered at the same time.

7. The method of forming a light-transmitting electromagnetic shield of claim 4 or 5, which is **characterized in that**, in the step in which the photosensitive conductive layer is exposed in a geometric pattern so as to define a specific pattern, the ratio St/Ss between the total surface area St of the unexposed regions and the total surface area Ss of the regions where the light-transmitting electromagnetic shield has been formed is at least 1 but not more than 99, the linewidth Ws is from 1 to 50 µm, the film thickness T is from 0.1 to 50 µm, and the shield is integrally formed with the substrate glass.

8. A photosensitive thick-film black electrically conductive paste material for forming a light-transmitting electromagnetic shield by application of a thick-film black paste, or lamination of the paste in the form of a sheet, onto a transparent glass substrate, exposure of the layer to actinic radiation in a desired geometric pattern, development of the patterned regions of the layer with a solvent, removal of the unexposed regions, firing of the remaining exposed regions that have been geometrically patterned, removal of the organic components, and sintering of the inorganic components; wherein the thick-film black conductive paste, or the same paste in the form of a sheet, is a mixture of a black pigment made of at least one from among ruthenium oxides, ruthenium polynary oxides, chromium oxides, iron oxide, titanium oxide, carbon black, nickel, nickel borate or a mixture thereof, optional conductive particles composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer.

9. A light-transmitting electromagnetic shield that is formed by applying onto a transparent glass substrate, or laminating in sheet form, a black electrically conductive paste composed of a mixture of a black pigment made of at least one from among ruthenium oxides, ruthenium polynary oxides, chromium oxides, iron oxide, titanium oxide, carbon black, nickel, nickel borate or a mixture thereof, optional conductive particles composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer, exposing the layer to actinic radiation in a geometric pattern, developing the patterned regions of the layer with a solvent, removing the unexposed regions, firing the remaining exposed regions that have been geometrically patterned, removing the organic components, and sintering the inorganic components.

10. The light-transmitting electromagnetic shield of claim 8 which is **characterized in that** the ratio St/Ss between the total surface area St of the unexposed regions and the total surface area Ss of the regions where the light-transmitting electromagnetic shield has been formed is at least 1 but not more than 99, the linewidth Ws is from 1 to 50 µm, the film thickness T is from 0.1 to 50 µm, and the shield is integrally formed with the substrate glass.

11. A method of forming a light-transmitting electromagnetic shield on a transparent glass substrate, the method being **characterized by** including:
(a) a step in which a black electrically conductive paste composed of a mixture of a black pigment made of at least one from among ruthenium oxides, ruthenium polynary oxides, chromium oxides, iron oxide, titanium oxide, carbon black, nickel, nickel borate or a mixture thereof, optional conductive particles composed of at least one type of metal selected from among silver, copper, nickel, palladium, gold, aluminum, tungsten, chromium, titanium, platinum and copper, nickel or ceramic powder coated on the surface with silver, or a combination thereof, at least one type of inorganic binder, an organic polymeric binder, a photoinitiator and a photocurable monomer is applied, or laminated in sheet form, onto the glass substrate;
(b) a step in which the layers are exposed to actinic radiation in a desired geometric pattern so as to definite a specific pattern;
(c) a step in which the exposed photosensitive conductive layer is developed in the patterned regions of the layer with a solvent, and the unexposed regions are removed; and
(d) a step in which the remaining exposed regions that have been geometrically patterned within the developed photosensitive conductive layer are fired, the organic components are removed, and the inorganic components are sintered.

12. The method of forming a light-transmitting electromagnetic shield of claim 11 which is **characterized in that** precious metals such as silver, palladium, gold and platinum within the thick-film conductive paste in the unexposed regions that have been removed in the development step (c) are refined so as to recycle the precious metal materials.

13. The method of forming a light-transmitting electromagnetic shield of claim 10 which is **characterized in that**, in the firing step (d), the glass substrate is fired in a tempering furnace or a half-tempering furnace so as to strengthen the glass substrate, and the photosensitive thick-film layer is sintered at the same time.

14. The method of forming a light-transmitting electromagnetic shield of claim 11 or 12 which is **characterized in that**, in the step in which the photosensitive conductive layer is exposed in a grid pattern so as to define a specific pattern, the ratio St/Ss between the total surface area St of the unexposed regions and the total surface area Ss of the regions where the light-transmitting electromagnetic shield has been formed is at least 1 but not more than 99, the linewidth Ws is from 1 to 50 µm, the film thickness T is from 0.1 to 50 µm, and the shield is integrally formed with the substrate glass.
